# EUROPEAN PATENT APPLICATION

(11) **EP 1 475 842 A1**
(43) Date of publication of application: **10.11.2004**
(21) Application number: 03705151.3
(22) Date of filing: 14.02.2003
(51) Int. Cl.: H01L 31/04

(54) **PHOTOVOLTAIC POWER GENERATING DEVICE, ATTACHMENT FOR PHOTOVOLTAIC POWER GENERATING DEVICE, AND ELECTRIC OR ELECTRONIC DEVICE**

(30) Priority: 14.02.2002 JP 2002037355; 22.03.2002 JP 2002081899
(71) Applicant: Sony Corporation, Tokyo 141-0001 (JP)
(72) Inventor: WATANABE, Haruo, c/o SONY CORPORATION, Tokyo 141-0001 (JP); YAMADA, Shinichiro, c/o SONY CORPORATION, Tokyo 141-0001 (JP); WATANABE, Tomikazu, c/o SONY CORPORATION, Tokyo 141-0001 (JP)
(74) Representative: Nicholls, Michael John
(86) International application number: PCT/JP2003/001540
(87) International publication number: WO 2003/069683

(57) **Abstract**

A photovoltaic device, which is applied as a power supply of a versatile electric or electronic apparatus as a substitute for a standard cell, while attaining, by using flexible photoelectric converting devices, availability as the power supply of the electric or electronic apparatus normally requiring light energy such as sunlight, a photovoltaic device attachment using the photovoltaic device and the electric or electronic apparatus using the photovoltaic device attachment are disclosed.

The photovoltaic device, the attachment thereof and the electric or electronic apparatus are characterized by having a core part and a photoelectric converting sheet having photoelectric converting devices, wherein a sheet part ranging from an inner end of an effective part of the photoelectric converting devices to an inner end of the photoelectric converting sheet and a sheet part ranging from an outer end of the effective part of the photoelectric converting devices to an outer end of the photoelectric converting sheet have the substantially same bending elasticity as the effective part of the photoelectric converting devices, an approximately cylindrical shape is presented as a whole in a condition where the photoelectric converting sheet is coiled around the core part, and detachable mounting to a housing part of a prescribed standard-shaped cell in the electric or electronic apparatus is possible.

## Description

### TECHNICAL FIELD

The present invention relates to a photovoltaic device using a photoelectric converting device. Also, the present invention relates to a photovoltaic device attachment using the photovoltaic device. Further, the present invention relates to an electric or electronic apparatus using the photovoltaic device attachment.

### BACKGROUND ART

A photoelectric converting device is also referred to as a solar cell, which is a device that converts light energy such as sunlight into electrical energy. In the case of generation of the electrical energy from the light energy, the photoelectric converting device yields no emission of a carbon dioxide etc., unlike a conventionally available fossil fuel etc. Further, the photoelectric converting device may generate the electrical energy from the light energy such as the sunlight that is considered to be a substantially inexhaustible source, so that power generation maybe performed semi-permanently. Thus, in view of a global environmental issue, the photoelectric converting device is presumed that an application and an available scope thereof would be extended increasingly in the future as well (See Japanese Patent Laid-open No. 2001-236999, 2001-230435 or 2001-237001, for instance).

However, the photoelectric converting device requires a large photo-detecting area to obtain a prescribed power output suited to utilization, by reason that the light energy such as the sunlight is in a spatially rare state.

On the other hand, downsizing of an electric or electronic apparatus is advanced with recent development of various fabrication technologies, so that various electric or electronic apparatuses increase in availability as a mobile apparatus. Thus, a handy-to-carry and easily available chemical cell is normally used for the electric or electronic apparatus as a power supply thereof. Accordingly, the chemical cell is presumed that an application thereof would be advanced increasingly in the future as well.

However, the chemical cell is normally available as a primary cell of a manganese dry cell and an alkali manganese dry cell etc., and is discarded after discharging is performed once, so that it is judged to be not preferable in terms of economical efficiency, resources and environmental load. While a secondary cell such as of NiMH system etc. having the same standard shape as the primary cell is also available, it is judged to be not preferable likewise the primary cell in view of low charging efficiency, if the power generation is performed by means of applying a load to a global environment (See Japanese Patent Laid-open No. 7-326371, 8-007899, 2001-217000 or 2000-30699, for instance). Accordingly, there has been a demand for the advent of a power generation unit using a compact and easy-to-handle solar cell.

However, a conventional photoelectric converting device is lack of flexibility, and is also deficient in portability because of a need for photoelectric converting devices as many as those corresponding to a light irradiation area required for obtaining a sufficient power output. By the way, it is in an outdoors that the sufficient power output is obtained with the photoelectric converting device, so that the electric or electronic apparatus being available outdoors is desired to be an electric or electronic apparatus superior in portability. For that purpose, a satisfactorily portable photoelectric converting device is required for the above photoelectric converting device.

Thus, the present invention is intended to provide a photovoltaic device being available, by using a photoelectric converting device having flexibility, as a power supply of an electric or electronic apparatus normally requiring the light energy such as the sunlight, the electric or electronic apparatus using the photovoltaic device and a photovoltaic device attachment used to connect the photovoltaic device to the electric or electronic apparatus.

### DISCLOSURE OF THE INVENTION

To solve the above problems, a photovoltaic device according to the present invention is a photovoltaic device having a core part and a photoelectric converting sheet having flexible photoelectric converting devices coiled around the core part in a freely drawn-able arrangement, wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices, an approximately cylindrical shape is presented as a whole in a condition where the photoelectric converting sheet having the photoelectric converting devices is coiled around the core part, and detachable mounting to a housing part of a prescribed standard-shaped cell in an electric or electronic apparatus is possible. Further, it also relates to the photovoltaic device wherein a layer arrangement of the above both sheet parts is substantially the same as that of the effective part of the photoelectric converting devices. Furthermore, it also relates to the photovoltaic device wherein the core part has, at the opposite ends thereof, an upper flange and a lower flange respectively formed in an approximately circular plate shape as an integral part of the core part, and furthermore, the photovoltaic device wherein a cylindrical-shaped outside wall is provided, which covers the photoelectric converting sheet having the photoelectric converting devices coiled around the core part and has a draw-out opening serving as a draw-out opening of the photoelectric converting sheet, the upper flange and the lower flange have supports for supporting outside wall turning freely in engagement with a side edge of the outside wall, and taking-up of the drawn-able photoelectric converting sheet having the photoelectric converting devices into an inside space formed by the core part and the outside wall is performed by turning the outside wall.

Another photovoltaic device according to the present invention is a photovoltaic device having a core part, a photoelectric converting sheet having flexible photoelectric converting devices coiled around the core part in a freely drawn-able arrangement, a housing part of the photoelectric converting sheet being put in a coiled position, and means for coiling the photoelectric converting sheet around the core part. Further, it also relates to the photovoltaic device wherein the photoelectric converting sheet has a plurality of photoelectric converting devices arranged in parallel to a longitudinal direction of the photoelectric converting sheet so as to be electrically connected in series. Furthermore, it also relates to the photovoltaic device wherein the photoelectric converting devices have, on a photo-detecting surface thereof, a polymer film protection layer. Furthermore, it also relates to the photovoltaic device wherein a piece of weight is connected to an outward end of the photoelectric converting sheet. Furthermore, it also relates to the photovoltaic device wherein an inner end of an effective part of the photoelectric converting devices in the photoelectric converting sheet is at the outside of a position substantially subjected to no interception of light in the drawn-out condition. Furthermore, it also relates to the photovoltaic device wherein a portion ranging from the inner end of the effective part of the photoelectric converting devices in the photoelectric converting sheet to an inner end of the photoelectric converting sheet and a portion ranging from an outer end of the effective part of the photoelectric converting devices in the photoelectric converting sheet to an outer end of the photoelectric converting sheet are substantially the same as the effective part of the photoelectric converting devices in layer arrangement so as to have the substantially same bending elasticity. Furthermore, it also relates to the photovoltaic device wherein the photoelectric converting sheet is provided with visual information.

A photovoltaic device attachment according to the present invention is a photovoltaic device attachment characterized by being electrically connected to an electric or electronic apparatus, while holding, in a photoelectric converting device drawn-out condition, a photovoltaic device having a core part and a photoelectric converting sheet having flexible photoelectric converting devices coiled around the core part in a freely drawn-able arrangement, wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices, an approximately cylindrical shape is presented as a whole in a condition where the photoelectric converting sheet having the photoelectric converting devices is coiled around the core part, and detachable mounting to a housing part of a prescribed standard-shaped cell in the electric or electronic apparatus is possible. Further, it also relates to the photovoltaic device attachment wherein a layer arrangement of the above both sheet parts is substantially the same as that of the effective part of the photoelectric converting devices. Furthermore, it also relates to the photovoltaic device attachment wherein the core part has, at the opposite ends thereof, an upper flange and a lower flange respectively formed in an approximately circular plate shape as an integral part of the core part, and furthermore, the photovoltaic device attachment wherein a cylindrical-shaped outside wall is provided, which covers the photoelectric converting sheet having the photoelectric converting devices coiled around the core part and has a draw-out opening serving as a draw-out opening of the photoelectric converting sheet, the upper flange and the lower flange have supports for supporting outside wall turning freely in engagement with a side edge of the outside wall, and taking-up of the drawn-able photoelectric converting sheet having the photoelectric converting devices into an inside space formed by the core part and the outside wall is performed by turning the outside wall.

Another photovoltaic device attachment according to the present invention is a photovoltaic device attachment characterized by being electrically connected to an electric or electronic apparatus, while holding the above photovoltaic device in the drawn-out condition of the photoelectric converting sheet having the photoelectric converting devices.

An electric or electronic apparatus according to the present invention is an electric or electronic apparatus containing a photovoltaic device attachment electrically connected to the electric or electronic apparatus, while holding, in a photoelectric converting device drawn-out condition, a photovoltaic device having a core part and a photoelectric converting sheet having flexible photoelectric converting devices coiled around the core part in a freely drawn-able arrangement, wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices, an approximately cylindrical shape is presented as a whole in a condition where the photoelectric converting sheet having the photoelectric converting devices is coiled around the core part, and detachable mounting to a housing part of a prescribed standard-shaped cell in the electric or electronic apparatus is possible. Further, it also relates to the photovoltaic device attachment wherein a layer arrangement of the above both sheet parts is substantially the same as that of the effective part of the photoelectric converting devices. Further, it also relates to the electric or electronic apparatus wherein the core part has, at the opposite ends thereof, an upper flange and a lower flange respectively formed in an approximately circular plate shape as an integral part of the core part, and furthermore, the electric or electronic apparatus wherein a cylindrical-shaped outside wall is provided, which covers the photoelectric converting sheet having the photoelectric converting devices coiled around the core part and has a draw-out opening serving as a draw-out opening of the photoelectric converting sheet, the upper flange and the lower flange have supports for supporting outside wall turning freely in engagement with a side edge of the outside wall, and taking-up of the drawn-able photoelectric converting sheet having the photoelectric converting devices into an inside space formed by the core part and the outside wall is performed by turning the outside wall.

Another electric or electronic apparatus according to the present invention is an electric or electronic apparatus containing the photovoltaic device according to the present invention connected thereto, more specifically, an electric or electronic apparatus containing a photovoltaic device attachment electrically connected to the electric or electronic apparatus, while holding a photovoltaic device having a core part, a photoelectric converting sheet having flexible photoelectric converting devices coiled around the core part in a freely drawn-able arrangement, a housing part of the photoelectric converting sheet being put in a coiled position, and means for coiling the photoelectric converting sheet around the core part, in a drawn-out condition of the photoelectric converting sheet having the photoelectric converting devices. Further, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which the photoelectric converting sheet has a plurality of photoelectric converting devices arranged in parallel to the longitudinal direction of the photoelectric converting sheet so as to be electrically connected in series. Furthermore, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which the photoelectric converting devices have, on a photo-detecting surface thereof, a polymer film protection layer.

Furthermore, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which a piece of weight is connected to an outward end of the photoelectric converting sheet. Furthermore, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which an inner end of an effective part of the photoelectric converting devices in the photoelectric converting sheet is at the outside of a position substantially subjected to no interception of light in the drawn-out condition. Furthermore, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which a portion ranging from the inner end of the effective part of the photoelectric converting devices in the photoelectric converting sheet to an inner end of the photoelectric converting sheet and a portion ranging from an outer end of the effective part of the photoelectric converting devices in the photoelectric converting sheet to an outer end of the photoelectric converting sheet are substantially the same as the effective part of the photoelectric converting devices in layer arrangement so as to have the substantially same bending elasticity. Furthermore, it also relates to the electric or electronic apparatus containing the photovoltaic device attachment electrically connected to the electric or electronic apparatus, while holding, in the drawn-out condition of the photoelectric converting sheet having the photoelectric converting devices, the photovoltaic device in which the photoelectric converting sheet is provided with visual information.

### BRIEF DESCRIPTION OF THE DRAWINGS

FIGS. 1A to 1D are views showing one embodiment of a photovoltaic device according to the present invention. FIG. 1B is a schematic view of the photovoltaic device in which a photoelectric converting sheet is in a drawn-out condition, and FIG. 1A is a cross sectional view of FIG. 1B. FIG. 1D is a schematic view of the photovoltaic device in which the photoelectric converting sheet is in a coiled condition, and FIG. 1C is a cross sectional view of FIG. 1D.
FIG. 2(b) is a view showing a condition before a photovoltaic device attachment containing the photovoltaic device in which the photoelectric converting sheet is in the drawn-out condition is connected to an electric or electronic apparatus, and FIG. 2(a) is a cross sectional view of FIG. 2(b).
FIG. 3B is a schematic view of the electronic or electric apparatus connected to the photovoltaic device attachment containing the photovoltaic device in which the photoelectric converting sheet is in the drawn-out condition, and FIG. 3A is a cross sectional view of FIG. 3B.
FIG. 4 is a typical view of a section of the photoelectric converting sheet.
FIG. 5A and FIG. 5C show a conventional photovoltaic device in which the photoelectric converting sheet is in a horizontally drawn-out condition. FIG. 5B and FIG. 5D show a photovoltaic device according to the present invention in which the photoelectric converting sheet is in the horizontally drawn-out condition.
FIG. 6B is a schematic view of a photovoltaic device having an outside wall, wherein the photoelectric converting sheet is in the drawn-out condition, and FIG. 6A is a cross sectional view of FIG. 6B. FIG. 6D is a schematic view of the photovoltaic device having the outside wall, wherein the photoelectric converting sheet is in the coiled condition, and FIG. 6C is a cross sectional view of FIG. 6D.
FIG. 7A and FIG. 7B are schematic views equal to FIG. 2 as seen from the back thereof.
FIG. 8B is a schematic view of a connector between the photovoltaic device attachment containing the photovoltaic device shown in FIGS. 1A to 1D and the electric apparatus, and FIG. 8A is a cross sectional view of FIG. 8B.
FIG. 9B is a view showing a condition before connection of the connector of FIGS. 8A and 8B between the photovoltaic device attachment and the electric apparatus, and FIG. 9A is a cross sectional view of FIG. 9B.
FIG. 10B is a schematic view of a connector between the photovoltaic device attachment containing the photovoltaic device shown in FIGS. 6A to 6D and the electric apparatus, and FIG. 10A is a cross sectional view of FIG. 10B.
FIG. 11B is a schematic view of the electric apparatus containing the photovoltaic device shown in FIGS. 1A to 1D, and FIG. 11A is a cross sectional view of FIG. 11B.
FIG. 12B is a schematic view of the electric apparatus containing the photovoltaic device shown in FIGS. 6A to 6D, and FIG. 12A is a cross sectional view of FIG. 12B.

### BEST MODE FOR CARRYING OUT THE INVENTION

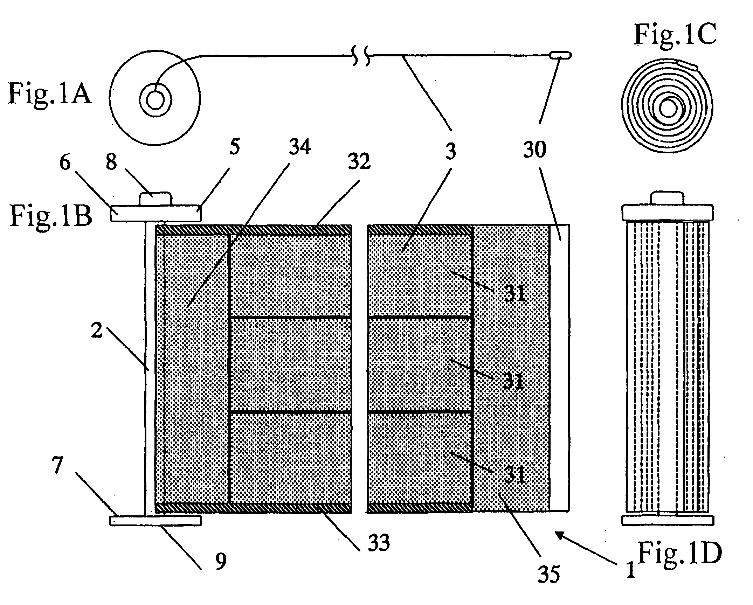

Embodiments of the present invention are hereinafter described in detail with reference to the accompanying drawings. However, as to a photoelectric converting sheet 3 in the drawings, a start portion and an end portion are shown, with an illustration of an intermediate portion thereof omitted. First of all, a photovoltaic device 1 shown in FIGS. 1 to 3 is described in the following. However, it is a matter of course that the present invention is not limited to these embodiments.

The photovoltaic device 1 according to the present invention is composed of a core part 2 and the photoelectric converting sheet 3 having flexible photoelectric converting devices 31 coiled around the core part 2 in a freely drawn-able arrangement, so as to present an approximately cylindrical shape as a whole with the photoelectric converting sheet 3 coiled around the core part 2.

The core part 2 is formed in a cylindrical shape with a resin material. Materials preferably available for the above resin material include, for instance, an ABS (acrylonitrile-butadiene-styrene) resin, a SAN (styrene-acrylamide) resin, an ASA (acrylonitrile-styrene-acrylamide) resin, an ACS (acrylonitrile-chlorinated polyethylene-styrene)resin or an AAS (acrylonitrile-acrylate-styrene) resin etc. The core part 2 is formed slightly longer than a width of the photoelectric converting sheet 3, with the photoelectric converting sheet 3 coiled. Thus, the core part 2 permits taking-up of the photoelectric converting devices 31 over a total width thereof to ensure that no projection of the photoelectric converting devices 31 arises. Also, the core part 2 has an upper flange 6 and a lower flange 7 at the opposite ends thereof, as required.

The upper flange 6 and the lower flange 7 are formed in an approximately circular plate shape with a resin material, and are fixed to the opposite ends of the core part 2 with a fixing means such as an adhesive. The resin material includes the resins as illustrated by the above resin materials, for instance, and may be the same material as the core part 2, or otherwise, a different material from that of the core part is also available. Preferably, the upper flange 6 and the lower flange 7 are formed such that a diameter of each flange is approximately equal to or more than a diameter of the photoelectric converting sheet 3 in a coiled condition around the core part 2. Hereby, the upper flange 6 and the lower flange 7 may protect a side edge of the coiled photoelectric converting sheet 3 around the core part 2 and is also adapted for a guide useful in taking up the drawn-able photoelectric converting sheet 3 around the core part 2 to ensure that the photoelectric converting sheet 3 may be coiled around the core part 2 without positional misalignment.

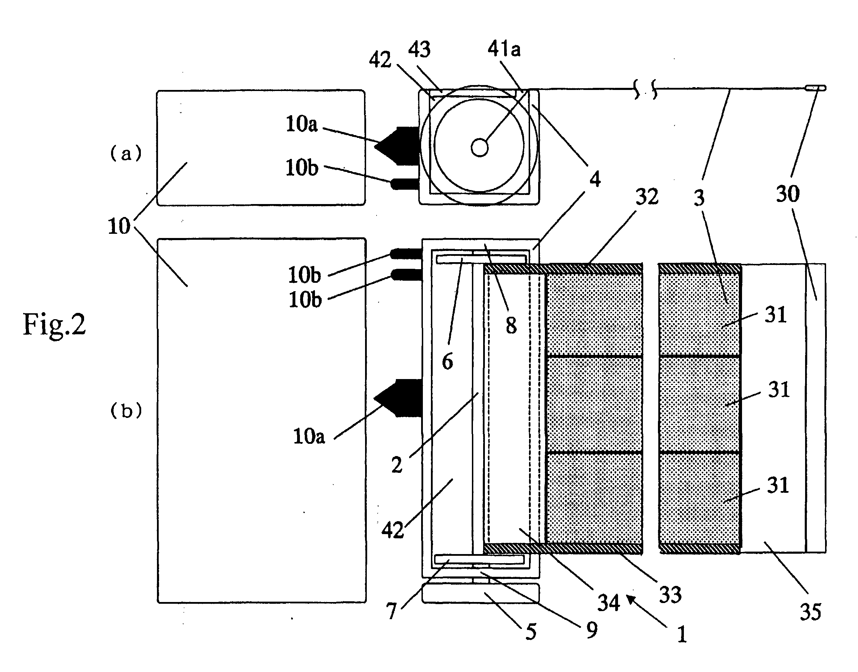

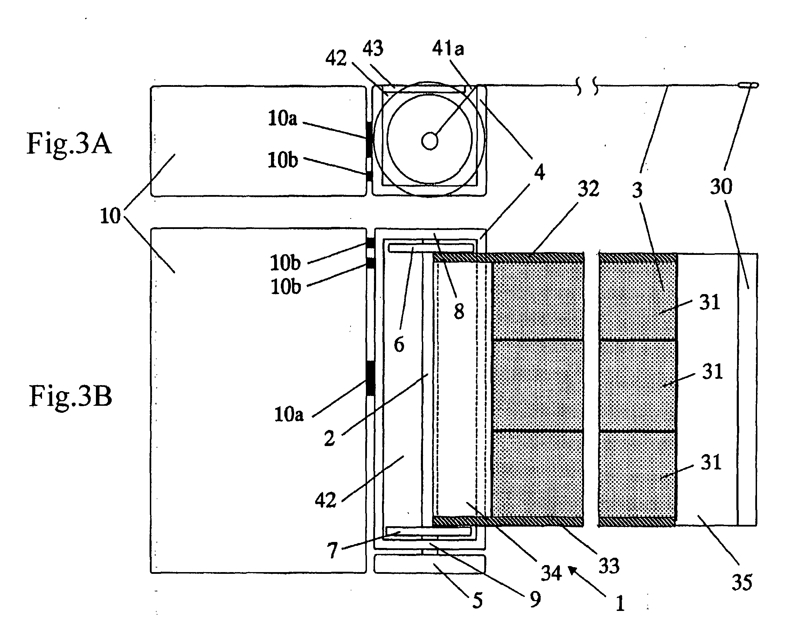

As shown in FIGS. 2, 3A and 3B, the upper flange 6, the lower flange 7, the core part 2 and the photoelectric converting sheet 3 coiled around the core part 2 are all housed in a housing space 42 of a photovoltaic device attachment 4. The photovoltaic device attachment 4 is formed in an enclosed arrangement with a housing cover 43 and a wall excepting the housing cover. Further, the wall has a bored slit 41a. The slit 41a is formed slightly larger in width and thickness than the photoelectric converting sheet 3. In the photovoltaic device 1, drawing-out of the photoelectric converting sheet 3 is performed freely outwards through the slit 41a. Further, formation of the slit 41a at the end of the housing cover 43 facilitates the drawing-out of the photoelectric converting sheet 3 for inspection and exchange, so that the slit 41a is considered to be a preferred configuration in the embodiment.

The photovoltaic device 1 is mechanically and electrically connected to an electric or electronic apparatus 10 through the photovoltaic device attachment 4, as shown in FIG. 2. The above mechanical connection is established through a connecting part 10a of the photovoltaic device attachment 4, and the above electrical connection is established through a pair of connecting parts 10b of the photovoltaic device attachment 4.

Further, the upper flange 6, the lower flange 7 and the core part 2 are mounted so as to be capable of turning about a center of the core part 2. In this case, the turning may be supported with supports 8 and 9 formed at the photovoltaic device attachment 4, for instance. Furthermore, a grip 5 may be attached to perform the turning externally.

It is preferable that the core part 2, the upper flange 6, the lower flange 7, the photovoltaic device attachment 4, the housing cover 43 and the grip 5 are formed with an electrically insulatingmaterial. Materials available for the above electrically insulating material include, in addition to liquid crystal polymers, for instance, chemical-resistant, heat-resistant and creep-resistant engineer plastics such as modified polyphenylene ether (PPE), polyether ether ketone (PEEK), polyphenylene sulfide (PPS), polyether sulfone (PES) or polysulfon (PSF) etc. Hereby, the photovoltaic device 1 according to the present invention may prevent short-circuiting of an inside interconnection through each of the above parts or electrical short-circuiting due to contact of each of the above parts with terminals etc. of the electric or electronic apparatus, for instance, when being applied to discharging.

It is also preferable that the core part 2, the upper flange 6, the lower flange 7, the photovoltaic device attachment 4, the housing cover 43 and the grip 5 are formed with an excellent heat insulating material. Materials available for the above excellent heat insulating material include, for instance, polyamide resins such as a para-aramide resin and a meta-aramide resin, polyvinyl chloride resins, polyester resins, polyethylene resins, polystyrene resins or polyurethane resins etc. Hereby, it is possible to prevent deformation or breakage due to a rise of temperature of the photovoltaic device 1 according to the present invention, in the case of exposure to a high temperature by being left on a dashboard of an automobile, for instance.

It is further preferable that the core part 2, the upper flange 6, the lower flange 7, the photovoltaic device attachment 4, the housing cover 43 and the grip 5 are colored in white or like color that hardly absorbs light and heat, for instance. Hereby, the photovoltaic device 1 may prevent the breakage due to the rise of temperature.

The upper flange 6 and the lower flange 7 have a positive terminal 18 and a negative terminal 19, respectively. The positive terminal 18 and the negative terminal 19 are formed with a conductive material, and are electrically connected to prescribed positions with non-illustrated connecting means, respectively. Materials available for the above conductive material include, for instance, metals such as aluminum, iron or nickel and metal alloys etc. such as an iron-nickel alloy, a copper-nickel alloy, a platinum-rhodium alloy or a gold-silver alloy etc.

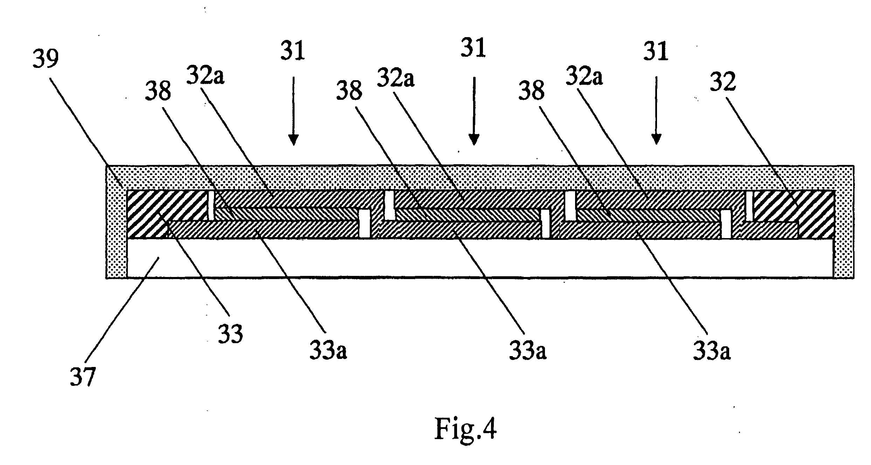

The photoelectric converting sheet 3 is composed of a flexible sheet-shaped substrate 37 formed in the shape of an approximately rectangular sheet and a plurality of photoelectric converting devices 31 arranged on the sheet-shaped substrate 37, as shown in a sectional view of FIG. 4. The sheet-shaped substrate 37 is formed with an insulating material such as polyester, for instance, in the shape of the sheet so as to have flexibility. Each photoelectric converting device 31 is obtained by forming, on the sheet-shaped substrate 37, a first electrode layer 33a, a photoelectric conversion layer 38 and a second electrode layer 32a respectively in the shape of a thin film in a sequentially multi-layer arrangement. Each layer contained in the photoelectric converting devices 31 is formed in the shape of the thin film on the sheet-shaped substrate using various PVD processes such as sputtering and evaporation or various CVD processes such as plasma CVD and MOCVD. The photoelectric converting devices 31 have sufficient flexibility, likewise the sheet-shaped substrate 37, because of an arrangement in which each layer is formed in the shape of the thin film.

In the photoelectric converting sheet 3, the photoelectric converting devices 31 are electrically connected to each other in series, and the electrode layers of the photoelectric converting devices 31 located at the opposite ends in a lateral direction have a positive terminal 32 and a negative terminal 33, respectively. The positive terminal 32 and the negative terminal 33 are electrically connected to prescribed positions through connecting members, respectively.

In addition, the photoelectric converting devices 31 have an arrangement in which incidence of light such as sunlight is provided through a main surface at a side opposite to the sheet-shaped substrate 37, that is, a side facing outwards. The first electrode layers 33a and the second electrode layers 32a are formed with a conductive material, thereby functioning as pairs of electrodes for the photoelectric conversion layers 38. The photoelectric conversion layers are formed in a film arrangement having a so-called photoelectric conversion effect by an arrangement in which an amorphous semiconductor thin film such as of a pin-junction of a-Si, for instance, is provided to ensure that photovoltaic power is generated by the incidence of the light such as the sunlight.

Alternatively, the photoelectric conversion layers may be of a pn-junction formed with p-type organic semiconductor such as perylene, for instance, and n-type organic semiconductor such as copper phthalocyanine, for instance. Incidentally, the photoelectric conversion layers are not limited to the above thin film structures, and may be those formed in any film arrangement having the photoelectric conversion effect with sufficient flexibility.

In the present invention, a polymer multi-layer sheet 39 having flexibility is further included. The polymer multi-layer sheet 39 is to cover a photo-detecting part of the photoelectric converting devices 31, and preferablly, a polymer multi-layer sheet portion adapted to covering provides at least light transmitting capability. Preferably, the polymer multi-layer sheet 39 is formed to cover the whole surface of the photoelectric converting sheet 3, more preferably, to project from the end of the photoelectric converting sheet 3 so as to protect the end of the photoelectric converting sheet 3. The polymer multi-layer sheet 39 may be provided only at the side of a photo-detecting surface of the photoelectric converting sheet 3 or an arrangement in which the polymer multi-layer sheet is further provided at the back of the photo-detecting surface of the photoelectric converting sheet 3 is also preferably available. Hereby, it is possible to reduce damages or deterioration of the flexible photoelectric converting devices 31 due to repeated bending of the photoelectric converting devices 31 when being used with a photo-detecting area enlarged by repeatedly drawing out the photoelectric converting devices 31. Further, the damages or deterioration of the photoelectric converting devices 31 may be prevented against repeated sliding motions of a surface with repeated drawing-out of the photoelectric converting devices 31 to ensure that power generation efficiency as the whole devices, in its turn, charging performance may be prevented from degradation. Further, when the photoelectric converting devices 31 are in a coiled condition over a long period of time, the photoelectric converting sheet 3 is plastically deformed (has a tendency to be easily curled) to hinder effective light detection of the photoelectric converting devices 31, in which case, however, plastic deformation may be reduced by the presence of the polymer multi-layer sheet 39 to ensure that the effective light detection is attainable. When the polymer multi-layer sheet 39 is required for the surface and the back surface of the photoelectric converting sheet 3 as described above, the surface-side and back surface-side polymer laminate sheets may be formed with the same sheet material, or appropriately different kinds of sheet materials are also available. A light-transmitting material is preferably required for the material to cover at least the photo-detecting part of the photoelectric converting devices 31. Further, a material having resistance to wear due to friction and weather resistance to light is also preferably required. Materials available for the above material include, for instance, a polymer of olefin halide, more specifically, fluorinated olefin or a copolymer of olefin and the above polymer. Further, an adhesive layer may be also provided to fix these sheets to the photoelectric converting sheet 3. Materials available for an adhesive layer material include a copolymer (EVA) of ethylene and vinyl acetate.

By the way, the first electrode layers 33a are formed with a metal material such as Ag, Al, Cr, Ni or Cu, for instance, preferably, formed so as to increase reflectance to light to be detected with the photoelectric conversion layers 38. Hereby, light transmitted through the photoelectric conversion layers 38 is reflected so as to come into again the photoelectric conversion layers 38 to ensure that photoelectric conversion efficiency of the photoelectric conversion layers 38 may be increased. It is also preferable that the second electrode layers 32a are formed as transparent electrodes with a material mainly containing a metal oxide such as SnO₂ or In₂O₃, for instance. Hereby, efficient transmission of light to be detected with the photoelectric conversion layers 38 is performed to ensure that the photoelectric conversion efficiency of the photoelectric conversion layers 38 may be increased.

Further, in the photoelectric converting sheet 3, the photoelectric converting devices 31 are arranged in parallel to the longitudinal direction of the photoelectric converting sheet. Specifically, pairs of electrode layers of the photoelectric converting devices 31 are placed in parallel to the longitudinal direction of the photoelectric converting sheet 3. Hereby, it is possible to prevent power generation efficiency as the whole photoelectric converting sheet from the degradation, even if a part of the photoelectric converting devices is not subjected to sufficient irradiation of light when the photoelectric converting sheet 3 is placed in the drawn-out condition for photovoltaic power generation.

Specifically, the photoelectric converting sheet 3 presents an elongate shape at the time of performing photovoltaic power generation by drawing out the photoelectric converting sheet 3, for instance, so that there may be a case where interception of light is caused by a shielding matter in a sidewise crossing manner. Even in this case, the photoelectric converting sheet 3 is effective in maintaining a sufficient power output at a position between the positive terminal 32 and the negative terminal 33 by approximately equal distribution of a screening effect of the photoelectric converting devices 31 among the photoelectric converting devices 3, by reason that the photoelectric converting devices 31 may perform power generation sufficiently at a portion subjected to irradiation of light, and also connection of the photoelectric converting devices 31 is established in series. Likewise, in the case where the photoelectric converting sheet 3 is placed in an incomplete drawn-out condition so that the interception of light is caused, the screening effect of the photoelectric converting devices 31 is distributed equally among the photoelectric converting devices 31. Further, in the case where the photoelectric converting sheet 3 is curled in the drawn-out condition so that non-uniformity of incident light arises, a power reduction at the position between the positive terminal 32 and the negative terminal 33 may be minimized by equal distribution of a quantity of light detected with the photoelectric converting devices 31.

Further, the photoelectric converting sheet 3 is coiled around the core part 2 in the freely drawn-able arrangement, wherein one side specified as an innermost side thereof is connected and fixed to the core part 2. The photoelectric converting sheet 3 is arranged that the positive terminal 32 and the negative terminal 33 described above are electrically connected to the one side specified as the innermost side. Herewith, the degradation of power generation efficiency may be prevented by an arrangement in which the ends of the photoelectric converting devices 31 of the photoelectric converting sheet 3 are in the drawn-out condition such that an inner end of an effective part of the photoelectric converting devices 31 in the photoelectric converting sheet 3 is at the outside of a position substantially subjected to no interception of light in the drawn-out condition. For that purpose, a sheet part 34 having no photoelectric converting device 31 but having the positive terminal 32 and the negative terminal 33 is interposed in the photoelectric converting sheet 3 ranging from a position where the one side specified as the innermost side of the photoelectric converting sheet 3 is connected and fixed to the core part 2 to the position substantially subjected to no interception of light in the drawn-out condition. Further, while the photoelectric converting sheet 3 has, at an outermost end, a piece of weight 30 working as an anchor part, the degradation of power generation efficiency may be also prevented by an arrangement in which the ends of the photoelectric converting devices 31 in the photoelectric converting sheet 3 are in the drawn-out condition such that an outer end of the effective part of the photoelectric converting devices 31 in the photoelectric converting sheet 3 is at the inside of the position substantially subjected to no interception of light with the piece of weight 30 in the drawn-out condition. For that purpose, a sheet part 35 having no photoelectric converting device 31 is interposed in the photoelectric converting sheet 3 ranging from a position where the one side specified as the outermost side of the photoelectric converting sheet 3 is connected and fixed to the piece of weight 30 to the position substantially subjected to no interception of light in the drawn-out condition. Then, in the photovoltaic device 1 of the present invention, the sheet part 34 having no photoelectric converting device 31 but having the positive terminal 32 and the negative terminal 33 is interposed in the photoelectric converting sheet 3 ranging from the one side specified as the innermost side of the photoelectric converting sheet 3 connected and fixed to the core part 2 to an end of the inner side of the photoelectric converting devices 31 of the photoelectric converting sheet 3 so as to be sufficiently locatedat the outside of the slit 41. Hereby, the interception of light in the photovoltaic device attachment 4 due to the insufficient drawing-out of the photoelectric converting devices 31 may be prevented in a charging operation. Further, the photoelectric converting devices 31 may be shifted from the inside of a high curvature toward the outside of a lower curvature to ensure that fatigue deterioration due to bending of the photoelectric converting devices 31 may be reduced.

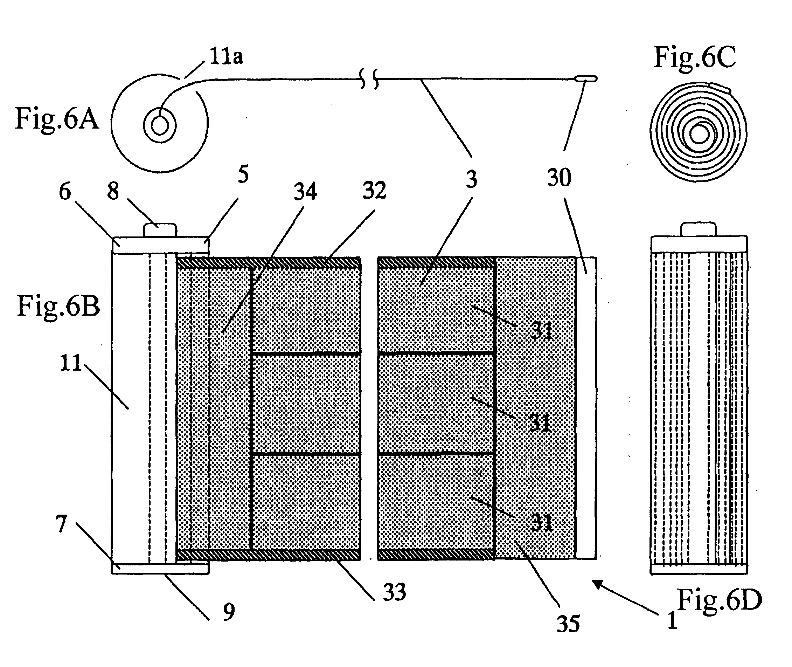

Further, in a photovoltaic device having an outside wall 11 as described later with reference to FIGS. 6A to 6D, the sheet part 34 having no photoelectric converting device 31 but having the positive terminal 32 and the negative terminal 33 is interposed in the photoelectric converting sheet 3 ranging from the one side specified as the innermost side of the photoelectric converting sheet 3 connected and fixed to the core part 2 to the end of the inner side of the photoelectric converting devices 31 of the photoelectric converting sheet 3 so as to be sufficiently located at the outside of a slit 11a of the outside wall 11. Hereby, the interception of light in the outside wall 11 due to the insufficient drawing-out of the photoelectric converting devices 31 may be prevented in the charging operation. Further, the photoelectric converting devices 31 may be shifted from the inside of the high curvature toward the outside of the lower curvature to ensure that the fatigue deterioration due to the bending of the photoelectric converting devices 31 may be reduced.

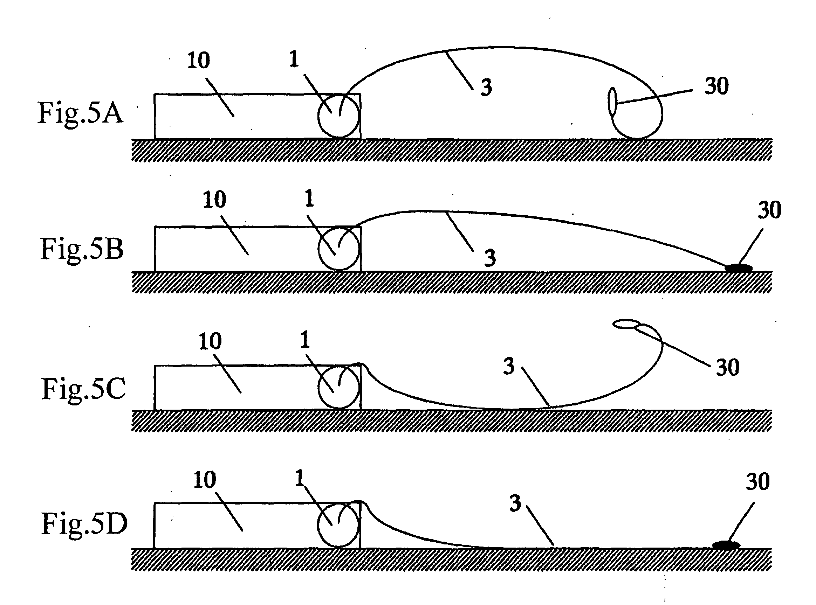

An operation of the piece of weight 30 working as the anchor part used by connection to the photoelectric converting sheet 3 of the present invention is now described with reference to FIGS. 5A to 5D. The piece of weight 30 is provided at a winding start part of the photoelectric converting sheet 3. The photoelectric converting sheet 3 is sometimes placed in the coiled condition within the photovoltaic device attachment for a long period of time. In this case, the photoelectric converting sheet 3 is subj ected to curling in a coiled direction at the time when uncoiling of the photoelectric converting sheet 3 is performed. Thus, in the case of development on a horizontal plane as shown in FIGS. 5A and 5C, the photoelectric converting sheet 3 fails to sufficiently catch light in a specific direction. Then, in the case of the development on the horizontal plane as shown in FIGS. 5B and 5D, the photoelectric converting sheet 3 is uncurled by the piece of weight 30 to ensure that the photoelectric converting sheet 3 is straightened along the horizontal plane over the substantially whole surface, and as a result, may catch light sufficiently in a vertical direction. In this case, the piece of weight 30 preferably requires a certain degree of mass even though being of a small size, and also preferably to be formed with a material which is hardly damaged even by collision against other matters when being used. Metals are preferably required as the material that meets these requirements. Further, metals having a large mass are required, and in terms of specific gravity, metals having the specific gravity at least equal to or more than 2.5, preferably, equal to or more than 5, more preferably, equal to or more than 7 are preferably required. Metals available for the above metals include, for instance, silver (10.49), aluminum (2.7), gold (19.32), bismuth (9.8), chromium (7.19), copper (8.93), iron (7.87), molybdenum (10.22), nickel (8.90), lead (11.36), platinum (21.45), tin (7.30), titanium (4.51), tungsten (19.3), zinc (7.13) or stainless steel (7.70) etc., wherein parenthesized numerical values represent the specific gravity (unit: g/cm³) at a temperature of about 25°C. In addition, a surface of each of these metals may be plated with a different metal, for instance, such as nickel and chromium, and copper whose surface is plated with nickel is preferably available. Further, the piece of weight is not limited in shape to a specific shape as shown in the drawings, for instance, and may be in any shape.

In the present invention, it is further preferable that the sheet part 34 ranging from the inner end of the effective part of the photoelectric converting devices 31 in the photoelectric converting sheet 3 to the inner end of the photoelectric converting sheet 3 and the sheet part 35 ranging from the outer end of the effective part of the photoelectric converting devices 31 in the photoelectric converting sheet 3 to the outer end of the photoelectric converting sheet 3 have the substantially same bending elasticity as the effective part of the photoelectric converting devices 31. The substantially same bending elasticity in this case means that a difference in bending elasticity between the sheet parts 34 and 35 and the photoelectric converting devices 31 is within the range of about 10%. To meet the above requirement, it is preferable that a layer arrangement of the sheet parts 34 and 35 is substantially the same as that of the photoelectric converting devices 31. Hereby, no bending arises in joints between the sheet parts 34 and 35 and the effective part of the photoelectric converting devices 31. Hereby, coiling of the photoelectric converting sheet 3 is performed uniformly to ensure that working durability of the photoelectric converting sheet 3 is increased.

On the other hand, bending arises in joints between the sheet part 34 having the positive terminal 32 and the negative terminal 33 and the effective part of the photoelectric converting devices 31 so that fatigue of the above terminal material is concentrated by concentration of the bending on bent parts specified as the joints between the sheet part 34 and the photoelectric converting devices 31 in the positive terminal 32 and the negative terminal 33, easily leading to a disconnection. Further, as to the whole photoelectric converting sheet 3, the bending also arises in the joints between the sheet parts 34 and 35 and the effective part of the photoelectric converting devices 31 so that the fatigue of the material is concentrated on this portion, easily leading to a breakage. To overcome the above wrong condition, it is preferable that the effective part of the photoelectric converting devices 31 and the sheet parts 34 and 35 have the same layer arrangement over the whole surface of the photoelectric converting sheet 3. The electrical connection and insulation between the effective part of the photoelectric converting devices 31 and other parts (the sheet parts 34 and 35) may be established by making use of an ordinary semiconductor process. The electrical disconnection between the effective part of the photoelectric converting devices 31 and the other parts (the sheet parts 34 and 35) may be performed by a procedure, for instance, in which the same layer structure is firstly fabricated using the ordinary semiconductor process, and thereafter, laser beams etc. are applied to a portion specified as a boundary between the effective part of the photoelectric converting devices 31 and parts (the sheet parts 34 and 35) to be electrically disconnected.

Further, the photoelectric converting sheet 3 is arranged with the photo-detecting surface thereof facing the inside in the coiled condition around the core part 2. Hereby, no exposure of the photo-detecting surface of the photoelectric converting devices 31 to the outside occurs when the photoelectric converting devices 31 are held in the coiled condition around the core part 2 to ensure that the breakage of the photo-detecting surface due to damages thereto may be prevented.

While in the above embodiment, the photoelectric converting devices 31 are arranged with the photo-detecting surface thereof facing the inside in the coiled condition around the core part 2, the present invention is not limited to the above arrangement, and may be also modified that the photoelectric converting devices 31 are arranged with the photo-detecting surface thereof facing the outside in the coiled condition around the core part 2.

It is also preferable that the photovoltaic device 1 of the present invention ranges in discharge voltage from about 0.6 to 1.9V or around. Hereby, the photovoltaic device 1 of the present invention, when being used for the electric or electronic apparatus using a normally available zinc standard cell as a power supply, may prevent a failure in operation due to a voltage less than an operating voltage of the electric or electronic apparatus 10, or a breakage of the apparatus due to a voltage exceeding a permissible voltage. For that purpose, a control circuit unit 15 may be included. The control circuit unit 15 is provided in a housed condition in an inside space of the core part 2 or in the upper flange 6 or the lower flange 7.

The control circuit unit 15 may be appropriately provided with a function selected from functions such as a rectifier function of preventing a counter flow between the photoelectric converting devices 31 and the electric or electronic apparatus 10, a function of preventing an application of an over-voltage to the electric or electronic apparatus 10 by the photoelectric converting devices 31 and a voltage stabilizing function of the photovoltaic device 1 of the present invention. The simplest means to obtain the above rectifier function of preventing the counter flow is to use a diode, wherein the above function is obtained by connecting plus terminals of the photoelectric converting devices 31 to an anode of the diode and by connecting a cathode of the diode to the connecting part 10b of the positive terminal 18 of the photovoltaic device 1. The above function is also obtained by connecting minus terminals of the photoelectric converting devices 31 to the cathode of the diode and by connecting the anode of the diode to the connecting part 10b of the negative terminal 19 of the photovoltaic device 1. Also, the simplest means to obtain the above function of preventing the application of the over-voltage or the above voltage stabilizing function is to use a Zener diode, wherein the above function is obtained by connecting a cathode of the Zener diode to the connecting part 10b of the positive terminal 18 of the photovoltaic device 1 and by connecting an anode of the Zener diode to the connecting part 10b of the negative terminal 19 of the photovoltaic device 1.

The photovoltaic device 1 for use in the photovoltaic device attachment according to the present invention is arranged as described above and presents the approximately cylindrical shape as a whole as shown in FIGS. 1A to 1D. The use of the photovoltaic device 1 in the photovoltaic device attachment 4 in this condition facilitates detachable mounting to the photovoltaic device attachment. Then, the photovoltaic device 1 for use in the photovoltaic device attachment according to the present invention is prescribed in dimensions etc. of each part so as to have a shape meeting prescribed tubular cell standards, with the photoelectric converting devices 31 coiled around the core part 2, as shown in FIGS.1A to 1D. Specifically, the photovoltaic device 1 includes cells prescribed by IEC and JIS etc. , such as a R20-type cell called a D type, a R14-type cell called a C type and a R6-type cell called an AA type. Hereby, the photovoltaic device 1 may be easily used for the electric or electronic apparatus designed that a normally available standard tubular cell is used in the housed condition. Thus, in this case, the photovoltaic device 1 may be applied, by converting the light energy such as the sunlight into the electrical energy, as the power supply of the electric or electronic apparatus using a tubular cell like the normally available cell.

Further, the photovoltaic device 1 for use in the photovoltaic device attachment according to the present invention generates power with the photoelectric converting sheet 3 drawn-able from the core part 2, as shown in FIGS. 1A to 1D. At this time, the photovoltaic device 1 may enlarge the photo-detecting area of the photoelectric converting devices 31, and also may direct the photoelectric converting devices 31 over the whole photo-detecting area toward the light, so that a power output of the photoelectric converting devices 31 may be increased.

Further, the photovoltaic device 1 according to the present invention may also have an arrangement in which the outside wall 11 is provided, as shown in FIGS. 6A to 6D. The photovoltaic device 1 having the arrangement in which the outside wall 11 is provided is described in the following. Incidentally, in the following description, the same parts or equivalents as those in the above description are designated with like reference numerals in the drawings, with a description thereof omitted.

As shown in FIG. 6B, the photovoltaic device 1 has the arrangement in which the outside wall 11 is provided, which presents an approximately cylindrical shape of a diameter approximately equal to that of each of the upper flange 6 and the lower flange 7. The photovoltaic device 1 has, at the upper flange 6 and the lower flange 7, supports for supporting outside wall turning freely in engagement with the side edge of the outside wall 11, respectively. Thus, in the photovoltaic device 1, the outside wall 11 freely turns about the core part 2, the upper flange 6 and the lower flange 7. The supports may be in the shape of a groove or a slant.

Further, as shown in FIG. 6A, the outside wall 11 has the bored slit 11a. The slit 11a is bored in the outside wall 11 in a width and a thickness respectively enough to draw out the photoelectric converting sheet 3.

Further, as shown in FIGS. 6A and 6B, the photovoltaic device 1 for use in the photovoltaic device attachment according to the present invention has, at the outermost end of the photoelectric converting sheet 3, the piece of weight 30 working as the anchor part. The piece of weight 30 is formed in a thickness enough to be joined with the slit 11a, when the photoelectric converting sheet 3 is placed in the coiled condition around the core part 2. The piece of weight 30 has a function of preventing the photoelectric converting devices 31 from being completely rolled up into the outside wall 11 and also functions as a grip useful in drawing out the photoelectric converting sheet 3.

As shown in FIGS. 6A and 6B, the photovoltaic device 1 for use in the photovoltaic device attachment according to the present invention allows the photoelectric converting sheet 3 to be drawn-able from the core part 2 by drawing out the piece of weight 30 when performing the power generation. Further, the photovoltaic device 1 also may take up the photoelectric converting sheet 3 around the core part 2 by turning the outside wall 11 about the core part 2.

Thus, the photovoltaic device 1 for use in the photovoltaic device attachment according to the present invention facilitates the drawing-out and taking-up of the photoelectric converting sheet 3 by the arrangement in which the outside wall 11 having the slit 11a is provided in the freely turning condition. Further, thanks to the arrangement in which the outside wall 11 is provided, the photovoltaic device 1 is free from loosening of the photoelectric converting sheet 3 at the time when the photoelectric converting sheet 3 is housed. Furthermore, thanks to the arrangement in which the outside wall 11 is provided, the photovoltaic device 1 for use in the photovoltaic device attachment according to the present invention protects the photoelectric converting devices 31 from the outside to ensure that the damages to the photoelectric converting devices 31 depending on the use and operation etc. of the photovoltaic device 1 may be prevented, and heating due to exposure to the direct rays of the sunlight may be also prevented. It is preferable that the outside wall 11 is colored in white or like color that hardly absorbs light and heat, for instance, to prevent the above heating more securely.

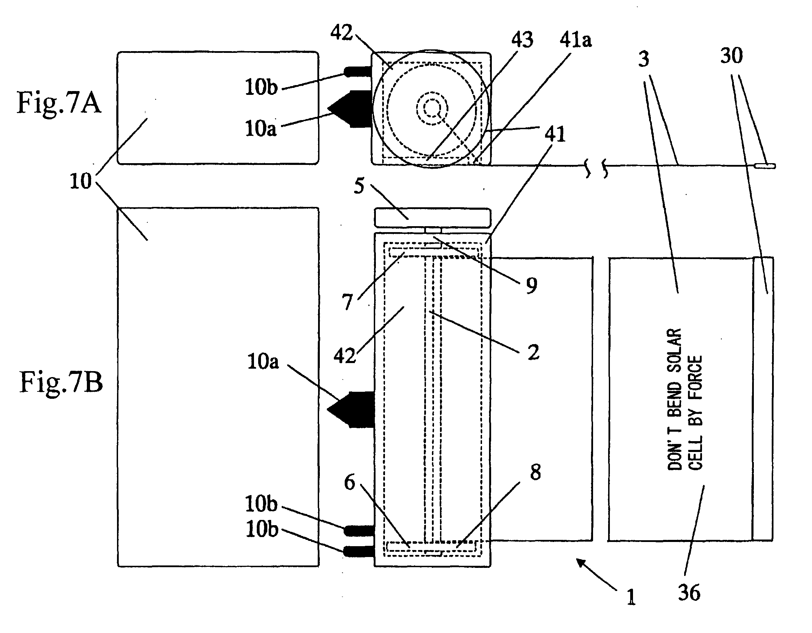

Further, it is also preferable that the photoelectric converting sheet 3 of the present invention is provided with visual information 36, as shown in FIGS. 7A and 7B. The visual information 36 may be provided at the winding start part of the photoelectric converting sheet 3. Further, the visual information 36 may be provided at an arbitrary portion ranging from the winding start part to a winding end part of the photoelectric converting sheet 3, preferably, at the winding start part. The visual information 36 may be formed at the back surface and/or the surface having the photoelectric converting devices 31 of the photoelectric converting sheet 3, preferably, at the back surface. Furthermore, formation on the photoelectric converting devices 31 in a practically allowable range of light transmitting capability is also possible. The visual information 36 may be formed on the photoelectric converting sheet 3 by printing. When the photoelectric converting sheet 3 has a protection layer, the visual information 36 may be formed on the protection layer by printing, in which case, however, if the protection layer has the light transmitting capability, the formation beneath the protection layer is preferably required in terms of preservation of the visual information 36 over a long period of time. The visual information 36 is information related to the given photovoltaic device, for instance, and includes how to handle, precautions in its use and features of the given device etc. Further, the visual information 36 may be information such as a maker name, a service center name and its address, telephone number and mail address, a logotype, a registered trademark and an advertisement. Furthermore, optical reading information such as barcodes is also included in the above visual information of the present invention. Hereby, a subsidiary instruction manual on the device of the present invention as a product becomes unnecessary or is simplified to ensure that a contribution toward resource savings is possible.

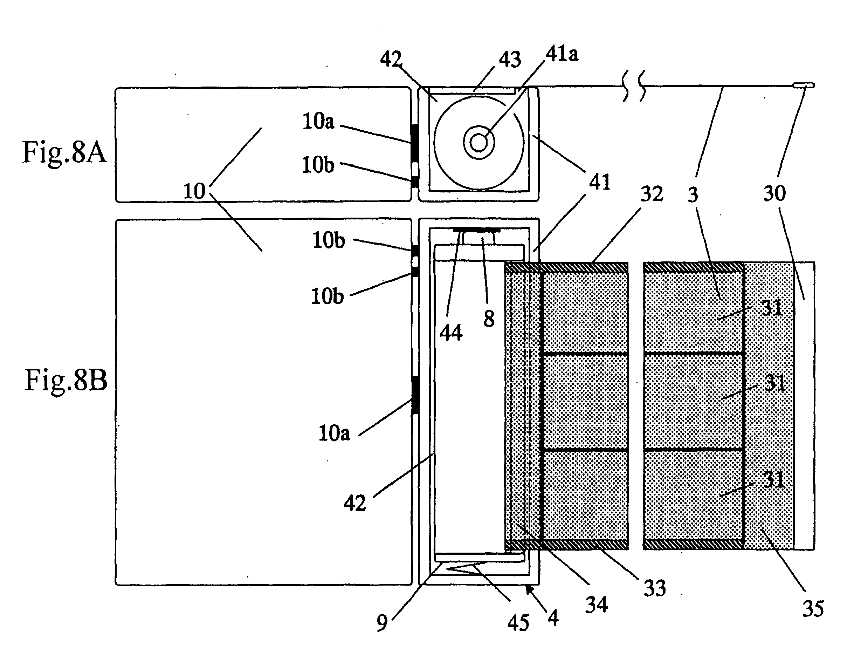

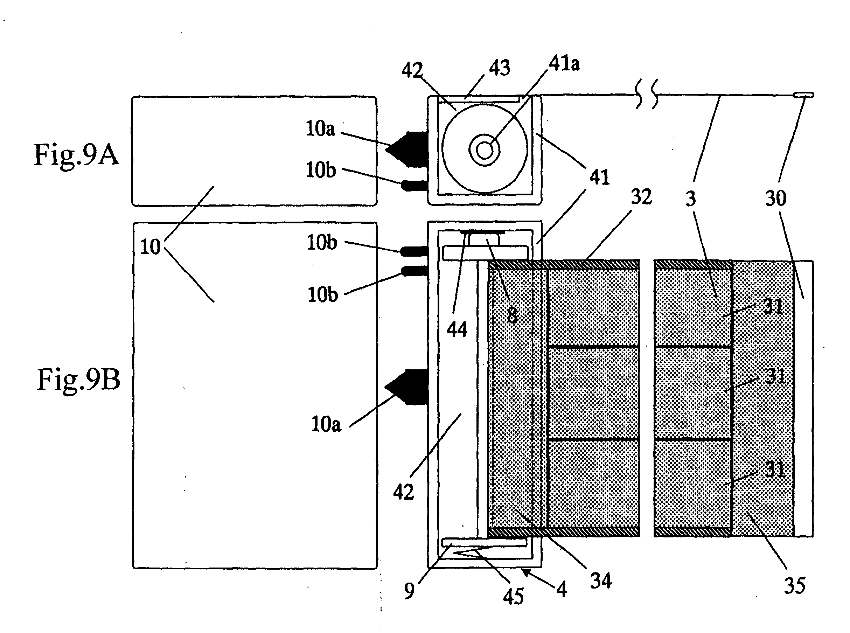

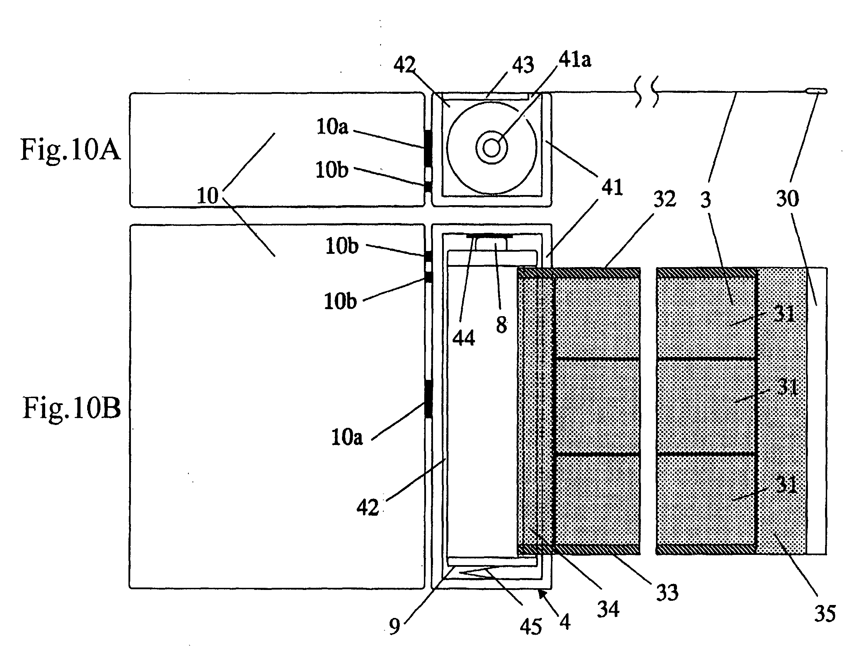

The photovoltaic device attachment according to the present invention and the electric or electronic apparatus using the same are now described. In the following, a description on the photovoltaic device attachment 4 as shown in FIGS. 8A to 10B and the electric or electronic apparatus 10 using the same is given. Incidentally, in FIGS. 8A to 10B, the electric or electronic apparatus 10 and the photovoltaic device attachment 4 are used in a mechanically and electrically connected condition. While one embodiment of a portable acoustic apparatus is illustrated as the pair of connectors, the present invention is not limited to the portable acoustic apparatus, and other various electrically operated apparatuses are also available. In the following description, members and parts related to the scope of the present invention are merely described in detail, without giving any description on members and parts contained in the portable acoustic apparatus.

The electric or electronic apparatus 10 and the photovoltaic device attachment 4 are connected together through the mechanical connecting part10a and the electrical connecting part 10b. The photovoltaic device attachment 4 is composed of an armoring member 41 and a housing space 42 for the photovoltaic device 1 enclosed with the above armoring member and a cell housing cover 43.

The photovoltaic device attachment 4 has a bored slit 41a. The slit 41a is formed slightly larger in width and thickness than the photoelectric converting sheet 3. In the photovoltaic device attachment 4, the drawing-out of the photoelectric converting sheet 3 from the armoring member 41 is performed freely outwards through the slit 41a. Further, the formation of the slit 41a at the end of the housing cover 43 facilitates the mounting of the photovoltaic device 1 with the photoelectric converting sheet 3 drawn-able, so that the slit 41a is considered to be a preferred configuration in the embodiment.

The electric or electronic apparatus 10 performs various operations by power supplied from the photovoltaic device attachment 4. The photovoltaic device attachment 4 has a positive terminal 44 and a negative terminal 45. The positive terminal 44 and the negative terminal 45 are electrically connected to the positive terminal 8 and the negative terminal 9 of the photovoltaic device 1, respectively. In the photovoltaic device attachment 4, an arrangement is adapted, in which the power is supplied to the photovoltaic device attachment 4 through the positive terminal 44 and the negative terminal 45, and further supplied to the electric or electronic apparatus 10 through the electrical connecting part 10b so that the electric or electronic apparatus 10 is operated.

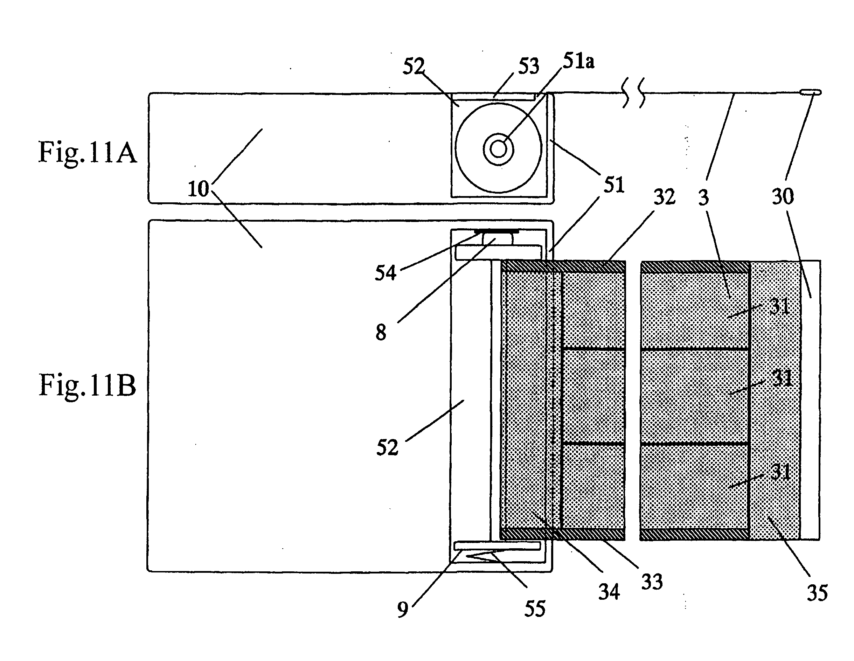

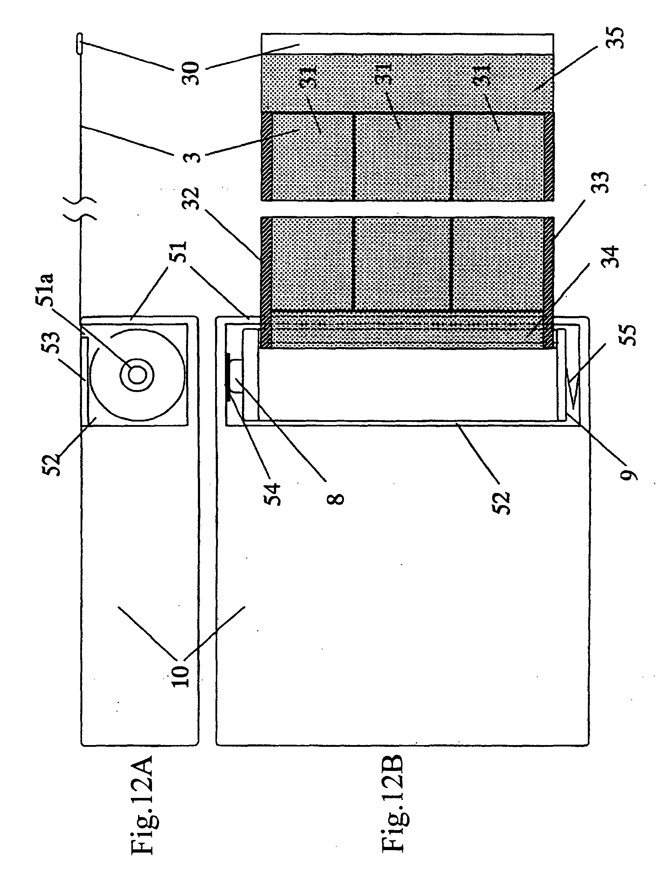

The electric or electronic apparatus according to the present invention is now described. In the following, a description on the photovoltaic device 1 as shown in FIGS. 11A to 12B and the electric or electronic apparatus 10 using the same is given. The electric or electronic apparatus 10 and the photovoltaic device 1 are used in the mechanically and electrically connected condition. While one embodiment of the portable acoustic apparatus is illustrated as the pair of connectors, the present invention is not limited to the portable acoustic apparatus, and other various electrically operated apparatuses are also available. Further, in the following description, the members and portions related to the scope of the present invention are merely described in detail, without giving any description on the members and portions contained in the portable acoustic apparatus.

The mechanical connection and the electrical connection between the electric or electronic apparatus 10 and the photovoltaic device 1 are established through a positive terminal 54 and a negative terminal 55 of the electric or electronic apparatus 10 and through the positive terminal 8 and the negative terminal 9 of the photovoltaic device 1, respectively. A housing space 52 of the photovoltaic device 1 in the electric or electronic apparatus 10 is formed with a space enclosed with an armoring member 51 and a housing cover 53.

The electric or electronic apparatus 10 has a bored slit 51a. The slit 51a is formed slightly larger in width and thickness than the photoelectric converting sheet 3. In the electric or electronic apparatus 10, the drawing-out of the photoelectric converting sheet 3 from the armoring member 51 is freely performed outwards through the slit 51a. Further, the formation of the slit 51a at the end of the housing cover 53 facilitates the mounting of the photovoltaic device 1 with the photoelectric converting sheet 3 drawn-able, so that the slit 51a is considered to be a preferred configuration in the embodiment.

The electric or electronic apparatus 10 performs various operations by the power supplied from the photovoltaic device 1. The electric or electronic apparatus 10 has the positive terminal 54 and the negative terminal 55. The positive terminal 54 and the negative terminal 55 are electrically connected to the positive terminal 8 and the negative terminal 9 of the photoelectric device 1, respectively. An arrangement is adapted, in which the power is supplied to the electric or electronic apparatus 10 through the above terminals for a charging operation, so that the electric or electronic apparatus 10 is operated by this power.

The upper flange 6 and the lower flange 7 have a positive terminal and a negative terminal, respectively. The positive terminal and the negative terminal are formed with a conductive material, and are electrically connected to the prescribed positions through non-illustrated connecting means, respectively. Materials available for the above conductive material include, for instance, metals such as aluminum, iron or nickel and metal alloys etc. such as an iron-nickel alloy, a copper-nickel alloy, a platinum-rhodium alloy or a gold-silver alloy etc.

The photoelectric converting devices 31 are so-called solar cells that are the flexible photoelectric converting devices formed in the shape of an approximately rectangular sheet. Specifically, each photoelectric converting device 31 is a device in which a reflection electrode layer having a metal electrode mainly containing silver (Ag), aluminum (Al) , chromium (Cr), nickel (Ni), copper (Cu) or carbon (C), for instance, a photoelectric conversion layer consisting of an amorphous semiconductor thin film such as of a pin junction of a-Si, and a transparent electrode layer mainly containing a metal oxide such as ZnO, SnO₂ or In₂O₃ are formed on an insulating film such as a polyester film, for instance, in a sequentially multi-layer arrangement in the shape of a thin film so as to have the flexibility. The photoelectric converting devices 31 have the layers formed in the shape of the thin film using the PVD process such as sputtering and evaporation or the CVD process such as plasma CVD and MOCVD. The photoelectric conversion layers may be of a pn junction formed with n-type organic semiconductor such as peleryne, for instance, and n-type organic semiconductor such as copper phthalocyanine, for instance.

The photoelectric converting sheet 3 is coiled around the core part 2 in the freely drawn-able arrangement, wherein one side specified as the innermost side thereof is fixed to the core part 2. The photoelectric converting sheet 3 has, at the one side specified as the innermost side, a positive terminal (not shown) and a negative terminal (not shown) , which are electrically connected to the prescribed positions through non-illustrated connecting means, respectively.

### INDUSTRIAL APPLICABILITY

The photovoltaic device according to the present invention is easily applied as the power supply of the normally available electric or electronic apparatus and is considered to be excellent in practical availability, since it is subjected to photo detection by drawing out the photoelectric converting devices coiled around the core part when performing the power generation. Thus, according to photovoltaic device, the photovoltaic device attachment and the electric or electronic apparatus of the present invention, the practical use of the light energy such as the sunlight as the power supply of the electric or electronic apparatus is attained to ensure that the effective utilization of global resources and the prevention of waste matter production are possible.

## Claims

1. A photovoltaic device, **characterized by** comprising:
a core part and a photoelectric converting sheet having flexible photoelectric converting devices coiled around said core part in a freely drawn-able arrangement;
wherein a sheet part ranging from an inner end of an effective part of the photoelectric converting devices in said photoelectric converting sheet to an inner end of the photoelectric converting sheet and a sheet part ranging from an outer end of the effective part of the photoelectric converting devices in said photoelectric converting sheet to an outer end of the photoelectric converting sheet have the substantially same bending elasticity as the effective part of the photoelectric converting devices;
an approximately cylindrical shape is presented as a whole in a condition where the photoelectric converting sheet having said photoelectric converting devices is coiled around said core part; and
detachable mounting to a housing part of a prescribed standard-shaped cell in an electric or electronic apparatus is possible.

2. The photovoltaic device according to claim 1:
wherein a layer arrangement of said both sheet parts is substantially the same as that of the effective part of the photoelectric converting devices.

3. The photovoltaic device according to claim 1:
wherein said core part has, at the opposite ends thereof, an upper flange and a lower flange respectively formed in an approximately circular plate shape as an integral part of said core part.

4. The photovoltaic device according to claim 1:
wherein a cylindrical-shaped outside wall is provided, which covers the photoelectric converting sheet having said photoelectric converting devices coiled around said core part and has a draw-out opening serving as a draw-out opening of said photoelectric converting sheet;
said upper flange and said lower flange have supports for supporting outside wall turning freely in engagement with a side edge of said outside wall; and
taking-up of the drawn-able photoelectric converting sheet having said photoelectric converting devices into an inside space formed by said core part and said outside wall is performed by turning said outside wall.

5. A photovoltaic device, **characterized by** comprising:
a core part;
a photoelectric converting sheet having flexible photoelectric converting devices coiled around said core part in a freely drawn-able arrangement;
a housing part of said photoelectric converting sheet being put in a coiled position; and
means for coiling said photoelectric converting sheet around said core part.

6. The photovoltaic device according to claim 5:
wherein the photoelectric converting sheet has a plurality of photoelectric converting devices arranged in parallel to a longitudinal direction of the photoelectric converting sheet so as to be electrically connected in series.

7. The photovoltaic device according to claim 5:
wherein the photoelectric converting devices have, on a photo-detecting surface thereof, a polymer film protection layer.

8. The photovoltaic device according to claim 5:
wherein a piece of weight is connected to an outward end of the photoelectric converting sheet.

9. The photovoltaic device according to claim 8:
wherein the piece of weight is formed with a material having specific gravity being equal to or more than 2.5.

10. The photovoltaic device according to claim 8:
wherein the piece of weight is formed with a metal.

11. The photovoltaic device according to claim 10:
wherein the metal includes copper whose surface may be plated with nickel.

12. The photovoltaic device according to claim 5:
wherein an inner end of an effective part of the photoelectric converting devices in the photoelectric converting sheet is at the outside of a position substantially subjected to no interception of light in the drawn-out condition.

13. The photovoltaic device according to claim 5:
wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices.

14. The photovoltaic device according to claim 13:
wherein a layer arrangement of the sheet part ranging from the inner end of the effective part of the photoelectric converting devices in the photoelectric converting sheet to the inner end of the photoelectric converting sheet and the sheet part ranging from the outer end of the effective part of the photoelectric converting devices in the photoelectric converting sheet to the outer end of the photoelectric converting sheet is substantially the same as that of the effective part of the photoelectric converting devices.

15. The photovoltaic device according to claim 5:
wherein the photoelectric converting sheet is provided with visual information.

16. The photovoltaic device according to claim 15:
wherein the visual information is provided at the back of a photo-detecting surface of the photoelectric converting devices of the photoelectric converting sheet.

17. The photovoltaic device according to claim 15:
wherein the visual information is printed on the photoelectric converting sheet.

18. The photovoltaic device according to claim 15:
wherein the visual information includes information related to the photovoltaic device.

19. A photovoltaic device attachment, **characterized by** being electrically connected to an electric or electronic apparatus, while holding, in a photoelectric converting device drawn-out condition, a photovoltaic device having a core part and a photoelectric converting sheet having flexible photoelectric converting devices coiled around said core part in a freely drawn-able arrangement;
wherein a sheet part ranging from an inner end of an effective part of the photoelectric converting devices in said photoelectric converting sheet to an inner end of the photoelectric converting sheet and a sheet part ranging from an outer end of the effective part of the photoelectric converting devices in said photoelectric converting sheet to an outer end of the photoelectric converting sheet have the substantially same bending elasticity as the effective part of the photoelectric converting devices;
an approximately cylindrical shape is presented as a whole in a condition where the photoelectric converting sheet having said photoelectric converting devices is coiled around said core part; and
detachable mounting to a housing part of a prescribed standard-shaped cell in the electric or electronic apparatus is possible.

20. The photovoltaic device attachment according to claim 19:
wherein a layer arrangement of said both sheet parts is substantially the same as that of the effective part of the photoelectric converting devices.

21. The photovoltaic device attachment according to claim 19:
wherein said core part has, at the opposite ends thereof, an upper flange and a lower flange respectively formed in an approximately circular plate shape as an integral part of said core part.

22. The photovoltaic device attachment according to claim 19:
wherein a cylindrical-shaped outside wall is provided, which covers the photoelectric converting sheet having said photoelectric converting devices coiled around said core part and has a draw-out opening serving as a draw-out opening of said photoelectric converting sheet;
said upper flange and said lower flange have supports for supporting outside wall turning freely in engagement with a side edge of said outside wall; and
taking-up of the drawn-able photoelectric converting sheet having said photoelectric converting devices into an inside space formed by said core part and said outside wall is performed by turning said outside wall.

23. A photovoltaic device attachment, **characterized by** being electrically connected to an electric or electronic apparatus, while holding a photovoltaic device having a core part, a photoelectric converting sheet having flexible photoelectric converting devices coiled around said core part in a freely drawn-able arrangement, a housing part of said photoelectric converting sheet being put in a coiled position, and means for coiling said photoelectric converting sheet around said core part, in a drawn-out condition of the photoelectric converting sheet having said photoelectric converting devices.

24. The photovoltaic device attachment according to claim 23:
wherein the photoelectric converting sheet has a plurality of photoelectric converting devices arranged in parallel to a longitudinal direction of the photoelectric converting sheet so as to be electrically connected in series.

25. The photovoltaic device attachment according to claim 23:
wherein the photoelectric converting devices have, on a photo-detecting surface thereof, a polymer film protection layer.

26. The photovoltaic device attachment according to claim 23:
wherein a piece of weight is connected to an outward end of the photoelectric converting sheet.

27. The photovoltaic device attachment according to claim 26:
wherein the piece of weight is formed with a material having specific gravity being equal to or more than 2.5.

28. The photovoltaic device attachment according to claim 26:
wherein the piece of weight is formed with a metal.

29. The photovoltaic device attachment according to claim 28:
wherein the metal includes copper whose surface may be plated with nickel.

30. The photovoltaic device attachment according to claim 23:
wherein an inner end of an effective part of the photoelectric converting devices in the photoelectric converting sheet is at the outside of a position substantially subjected to no interception of light in the drawn-out condition.

31. The photovoltaic device attachment according to claim 23:
wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices.

32. The photovoltaic device attachment according to claim 31:
wherein a layer arrangement of the sheet part ranging from the inner end of the effective part of the photoelectric converting devices in the photoelectric converting sheet to the inner end of the photoelectric converting sheet and the sheet part ranging from the outer end of the effective part of the photoelectric converting devices in the photoelectric converting sheet to the outer end of the photoelectric converting sheet is substantially the same as that of the effective part of the photoelectric converting devices.

33. The photovoltaic device attachment according to claim 23:
wherein the photoelectric converting sheet is provided with visual information.

34. The photovoltaic device attachment according to claim 33:
wherein the visual information is provided at the back of a photo-detecting surface of the photoelectric converting devices of the photoelectric converting sheet.

35. The photovoltaic device attachment according to claim 33:
wherein the visual information is printed on the photoelectric converting sheet.

36. The photovoltaic device attachment according to claim 33:
wherein the visual information includes information related to the photovoltaic device.

37. An electric or electronic apparatus, **characterized by** containing a photovoltaic device attachment electrically connected to the electric or electronic apparatus, while holding, in a photoelectric converting device drawn-out condition, a photovoltaic device having a core part and a photoelectric converting sheet having flexible photoelectric converting devices coiled around said core part in a freely drawn-able arrangement;
wherein a sheet part ranging from an inner end of an effective part of the photoelectric converting devices in said photoelectric converting sheet to an inner end of the photoelectric converting sheet and a sheet part ranging from an outer end of the effective part of the photoelectric converting devices in said photoelectric converting sheet to an outer end of the photoelectric converting sheet have the substantially same bending elasticity as the effective part of the photoelectric converting devices;
an approximately cylindrical shape is presented as a whole in a condition where the photoelectric converting sheet having said photoelectric converting devices is coiled around said core part; and
detachable mounting to a housing part of a prescribed standard-shaped cell in the electric or electronic apparatus is possible.

38. The electric or electronic apparatus according to claim 37:
wherein a layer arrangement of said both sheet parts is substantially the same as that of the effective part of the photoelectric converting devices.

39. The electric or electronic apparatus according to claim 37:
wherein said core part has, at the opposite ends thereof, an upper flange and a lower flange respectively formed in an approximately circular plate shape as an integral part of said core part.

40. The electric or electronic apparatus according to claim 37:
wherein a cylindrical-shaped outside wall is provided, which covers the photoelectric converting sheet having said photoelectric converting devices coiled around said core part and has a draw-out opening serving as a draw-out opening of said photoelectric converting sheet;
said upper flange and said lower flange have supports for supporting outside wall turning freely in engagement with a side edge of said outside wall; and
taking-up of the drawn-able photoelectric converting sheet having said photoelectric converting devices into an inside space formed by said core part and said outside wall is performed by turning said outside wall.

41. An electric or electronic apparatus, **characterized by** containing a photovoltaic device attachment electrically connected to the electric or electronic apparatus, while holding a photovoltaic device having
a core part,
a photoelectric converting sheet having flexible photoelectric converting devices coiled around said core part in a freely drawn-able arrangement,
a housing part of said photoelectric converting sheet being put in a coiled position, and
means for coiling said photoelectric converting sheet around said core part, in a drawn-out condition of the photoelectric converting sheet having said photoelectric converting devices.

42. The electric or electronic apparatus according to claim 41:
wherein the photoelectric converting sheet has a plurality of photoelectric converting devices arranged in parallel to a longitudinal direction of the photoelectric converting sheet so as to be electrically connected in series.

43. The electric or electronic apparatus according to claim 41:
wherein the photoelectric converting devices have, on a photo-detecting surface thereof, a polymer film protection layer.

44. The electric or electronic apparatus according to claim 41:
wherein a piece of weight is connected to an outward end of the photoelectric converting sheet.

45. The electric or electronic apparatus according to claim 44:
wherein the piece of weight is formed with a material having specific gravity being equal to or more than 2.5.

46. The electric or electronic apparatus according to claim 44:
wherein the piece of weight is formed with a metal.

47. The electric or electronic apparatus according to claim 46:
wherein the metal includes copper whose surface may be plated with nickel.

48. The electric or electronic apparatus according to claim 41:
wherein an inner end of an effective part of the photoelectric converting devices in the photoelectric converting sheet is at the outside of a position substantially subjected to no interception of light in the drawn-out condition.

49. The electric or electronic apparatus according to claim 41:
wherein a sheet part ranging from an inner end of an effective part of the photoelectric converting devices in the photoelectric converting sheet to an inner end of the photoelectric converting sheet and a sheet part ranging from an outer end of the effective part of the photoelectric converting devices in the photoelectric converting sheet to an outer end of the photoelectric converting sheet have the substantially same bending elasticity as the effective part of the photoelectric converting devices.

50. The electric or electronic apparatus according to claim 49:
wherein a layer arrangement of the sheet part ranging from the inner end of the effective part of the photoelectric converting devices in the photoelectric converting sheet to the inner end of the photoelectric converting sheet and the sheet part ranging from the outer end of the effective part of the photoelectric converting devices in the photoelectric converting sheet to the outer end of the photoelectric converting sheet is substantially the same as that of the effective part of the photoelectric converting devices.

51. The electric or electronic apparatus according to claim 41:
wherein the photoelectric converting sheet is provided with visual information.

52. The electric or electronic apparatus according to claim 51:
wherein the visual information is provided at the back of a photo-detecting surface of the photoelectric converting devices of the photoelectric converting sheet.

53. The electric or electronic apparatus according to claim 51:
wherein the visual information is printed on the photoelectric converting sheet.

54. The electric or electronic apparatus according to claim 51:
wherein the visual information includes information related to the photovoltaic device.

55. A method of manufacturing an electric or electronic apparatus containing a photovoltaic device through a photovoltaic device attachment, said method, **characterized by** combining, with one another,
(a) the photovoltaic device having a core part and a photoelectric converting sheet having flexible photoelectric converting devices coiled around said core part in a freely drawn-able arrangement, wherein a sheet part ranging from an inner end of an effective part of the photoelectric converting devices in said photoelectric converting sheet to an inner end of the photoelectric converting sheet and a sheet part ranging from an outer end of the effective part of the photoelectric converting devices in said photoelectric converting sheet to an outer end of the photoelectric converting sheet have the substantially same bending elasticity as the effective part of the photoelectric converting devices, an approximately cylindrical shape is presented as a whole in a condition where the photoelectric converting sheet having the photoelectric converting devices is coiled around said core part, and detachable mounting to a housing part of a prescribed standard-shaped cell in the electric or electronic apparatus is possible;
(b) the photovoltaic device attachment electrically connected to the electric or electronic apparatus, while holding said photovoltaic device in a drawn-out condition of the photoelectric converting sheet having said photoelectric converting devices; and
(c) the electric or electronic apparatus.

56. A method of manufacturing an electric or electronic apparatus containing a photovoltaic device attachment, said method, **characterized by** combining, with each other,
(d) the photovoltaic device attachment electrically connected to the electric or electronic apparatus, while holding a photovoltaic device having a core part, a photoelectric converting sheet having flexible photoelectric converting devices coiled around said core part in a freely drawn-able arrangement, a housing part of said photoelectric converting sheet being put in a coiled position, and means for coiling said photoelectric converting sheet around said core part, in a drawn-out condition of the photoelectric converting sheet having said photoelectric converting devices; and
(e) the electric or electronic apparatus.
